# EUROPÄISCHE PATENTSCHRIFT

(11) **EP 3 068 921 B1**
(45) Veröffentlichungstag und Bekanntmachung des Hinweises auf die Patenterteilung: **16.09.2020**
(21) Anmeldenummer: 15700967.1
(22) Anmeldetag: 08.01.2015
(51) Int. Cl.: C23C 14/06, F01D 5/28, C23C 4/10, C23C 4/02, C23C 14/02, C23C 28/00

(54) **VERDICHTERSCHAUFEL MIT EROSIONSBESTÄNDIGER HARTSTOFFBESCHICHTUNG**
COMPRESSOR BLADE WITH EROSION RESISTANT HARD MATERIAL COATING
AUBE DE COMPRESSEUR DOTÉE D'UN REVÊTEMENT DUR RÉSISTANT À LA CORROSION

(30) Priorität: 14.02.2014 EP 14155135
(43) Veröffentlichungstag der Anmeldung: 21.09.2016
(73) Patentinhaber: Siemens Aktiengesellschaft, 80333 München (DE)
(72) Erfinder: FLORES RENTERIA, Arturo, 12161 Berlin (DE); NEDDEMEYER, Torsten, 14612 Falkensee (DE)
(86) Internationale Anmeldenummer: PCT/EP2015/050225
(87) Internationale Veröffentlichungsnummer: WO 2015/121000

(56) Entgegenhaltungen:
- EP-A1- 2 684 982
- EP-A2- 0 718 419
- US-A1- 2009 011 195
- US-A1- 2011 052 406

## Beschreibung

### Technisches Gebiet

Die Erfindung betrifft eine Verdichterschaufel für eine Gasturbine, einen Verdichter mit einer solchen Verdichterschaufel und ein Herstellungsverfahren für eine solche Verdichterschaufel.

### Technischer Hintergrund

Bei Gasturbinen wird im Rahmen der sogenannten "Wet Compression" Wasser in die von einem Verdichter verdichtete Verbrennungsluft gegeben, was aufgrund des dadurch bewirkten Kühlungseffektes und der Erhöhung des Massenstromes in der Gasturbine zu einer Erhöhung des Wirkungsgrades der Gasturbine führt. Das Wasser wird möglichst fein zerstäubt, jedoch kommt es aufgrund der Tropfen in der Verbrennungsluft zu Erosion an den Verdichterschaufeln. Zudem bewirkt die Feuchtigkeit eine verstärkte Korrosion. Bisher wurden Verdichterschaufeln mit Korrosionsschutzschichten wie Sicoat 8610 beschichtet, die jedoch keinen hinreichenden Erosionsschutz bieten. Die Erfindung macht es sich daher zur Aufgabe, eine robuste Verdichterschaufel einzuführen, die der beim Wet Compression Verfahren erhöhten Erosionslast länger standhalten kann.

Verdichterschaufel und Turbinenkomponente aufweisend eine Al-enthaltene Anbindungsschicht und eine Hartstoffbeschichtung, sowie Herstellungsverfahren dafür, werden in US 2009/011195 A1, EP 2 684 982 A1, US 2011/052406 A1 und EP 0 718 419 A2 offenbart.

### Zusammenfassung der Erfindung

Die Erfindung führt daher eine Verdichterschaufel für eine Gasturbine ein. Die Verdichterschaufel verfügt über ein Schaufelsubstrat, das aus einer Metalllegierung besteht und an einer Oberfläche des Schaufelsubstrates eine Aluminiumdiffusionszone aufweist. Außerdem verfügt die Verdichterschaufel über eine auf der Oberfläche des Schaufelsubstrates angeordnete Hartstoffbeschichtung.

Die erfindungsgemäße Verdichterschaufel besitzt den Vorteil einer größeren Erosionsbeständigkeit aufgrund der auf das Schaufelsubstrat aufgebrachten Hartstoffbeschichtung. Die Hartstoffbeschichtung bietet auch einen Korrosionsschutz. Problematisch an solchen Hartstoffbeschichtungen ist jedoch, dass sie lokal abplatzen können. Dadurch kann an einer derart freigelegten Stelle des Schaufelsubstrates Korrosion einsetzen, die durch Unterkorrosion das weitere Abplatzen der Hartstoffbeschichtung begünstigt. Durch das Abplatzen wird die Verdichterschaufel schließlich der Erosion preisgegeben. Die Erfindung löst dieses Problem durch eine Aluminiumdiffusionsschicht; das in dieser Aluminiumdiffusionsschicht enthaltene Aluminium reagiert bei einem Abplatzen der Hartstoffbeschichtung zu Aluminiumoxid, das die Metalllegierung des Schaufelsubstrates vor Korrosion schützt. Eine Unterkorrosion, die bis zu einem Schaufelabriss führen kann, wird auf diese Weise verhindert.

Die Hartstoffbeschichtung besteht aus TiN, TiAlN, AlTiN, CrN als Ein- oder Mehrschichtkeramiken oder enthält TiN, TiAlN, AlTiN, CrN als Ein- oder Mehrschichtkeramiken. Diese Materialien bieten als Hartstoffbeschichtung eine besonders hohe Beständigkeit gegenüber Erosions- und Korrosionslasten.

Die Aluminiumdiffusionszone weist eine Dicke von 10 bis 30 Mikrometer, vorzugsweise von 15 bis 25 Mikrometer, auf.

Eine Aluminiumdiffusionszone von ungefähr 20 Mikrometern Dicke kann genügend Aluminium aufnehmen, um die erfindungsgemäße hartstoffbeschichtete Verdichterschaufel während wenigstens 100.000 Betriebsstunden vor Korrosion zu schützen.

Die Aluminiumdiffusionszone der Verdichterschaufel weist einen Aluminiumanteil von 0,05 bis 0,2 Gewichtsprozent, vorzugsweise von 0,075 bis 0,15 Gewichtsprozent, auf. Ein Aluminiumanteil von ungefähr 0,1 Gewichtsprozent stellt genügend Aluminium bereit, um einen zuverlässigen Korrosionsschutz der erfindungsgemäßen hartstoffbeschichteten Verdichterschaufel zu gewährleisten. Der Fachmann kann jedoch in Abhängigkeit von den jeweiligen Betriebsbedingungen durch Modellierung für den jeweiligen Einzelfall geeignete Schichtdicken, Aluminiumanteile und/oder Diffusionsprofile bestimmen.

Die Metalllegierung der Verdichterschaufel ist ein kriechfester Stahl, beispielsweise ein kriechfester Stahl gemäß EN 10302:2008. Ein Beispiel für einen geeigneten Stahl ist X22CrNiMoV12-1. Kriechfeste Stähle stellen ein preisgünstiges Material dar, das den hohen mechanischen Belastungen, denen eine Verdichterschaufel einer Gasturbine im Betrieb unterliegt, bei den dort herrschenden nur mäßigen Temperaturen standhält.

Ein zweiter Aspekt der Erfindung betrifft einen Verdichter für eine Gasturbine, der eine Mehrzahl von Verdichterschaufeln aufweist, von denen wenigstens eine Verdichterschaufel gemäß dem ersten Erfindungsaspekt ausgebildet ist.

Die Mehrzahl von Verdichterschaufeln kann in einer Mehrzahl von Reihen angeordnet sein, wobei jede Reihe eine Mehrzahl von quer zu einer Hauptströmungsrichtung des Verdichters angeordneten Verdichterschaufeln aufweist. Außerdem können die Reihen entlang der Hauptströmungsrichtung benachbart angeordnet sein. Vorzugsweise sind dabei die Verdichterschaufeln der entlang der Hauptströmungsrichtung ersten bis vierten Reihe von Verdichterschaufeln gemäß dem ersten Erfindungsaspekt ausgebildet. Die Verdichterschaufeln der ersten bis vierten Reihe des Verdichters sind am stärksten der Erosion ausgesetzt, weshalb hier die erfindungsgemäßen Verdichterschaufeln besonders vorteilhaft eingesetzt werden können.

Ein weiterer Erfindungsaspekt führt ein Herstellungsverfahren gemäß Anspruch 4 für eine erfindungsgemäße Verdichterschaufel ein. Das Verfahren verfügt wenigstens über die folgenden Schritte:
-- Bereitstellen eines Schaufelsubstrates aus einer Metalllegierung, bei der die Metalllegierung ein kriechfester Stahl ist;
-- Eindiffundieren von Aluminium in eine Oberflächenzone des Schaufelsubstrates; und
-- Beschichten des Schaufelsubstrates mit einer

Hartstoffbeschichtung (4), bei der die Hartstoffbeschichtung (4) aus TiN, TiAlN, AlTiN, CrN als Ein- oder Mehrschichtkeramiken besteht oder TiN, TiAlN, AlTiN, CrN als Ein- oder Mehrschichtkeramiken enthält.

Es wird dabei im Schritt des Eindiffundierens von Aluminium in die Oberflächenzone eine Aluminiumdiffusionszone einer Dicke von 10 bis 30 Mikrometer, vorzugsweise von 15 bis 25 Mikrometer, erzeugt.

Darüber hinaus wird der Schritt des Eindiffundierens von Aluminium in die Oberflächenzone derart ausgeführt, dass in der Oberflächenzone ein Aluminiumanteil von 0,05 bis 0,2 Gewichtsprozent, vorzugsweise von 0,075 bis 0,15 Gewichtsprozent, vorliegt.

In dem Schritt des Beschichtens des Schaufelsubstrates mit einer Hartstoffbeschichtung kann ein Schritt des physikalischen Gasphasenabscheidens oder des thermischen Plasmaspritzens durchgeführt werden.

### Kurzbeschreibung der Abbildungen

Die Erfindung wird nachfolgend anhand von Abbildungen von Ausführungsbeispielen näher erläutert. Es zeigen:
Figur 1 ein Beispiel einer Gasturbine 100 in einem Längsteilschnitt;
Figur 2 eine Laufschaufel oder Leitschaufel einer Gasturbine in perspektivischer Ansicht;
Figur 3 eine Brennkammer einer Gasturbine; und
Figur 4 eine Teilansicht eines Querschnitts durch eine erfindungsgemäße Verdichterschaufel.

### Ausführliche Beschreibung der Abbildungen

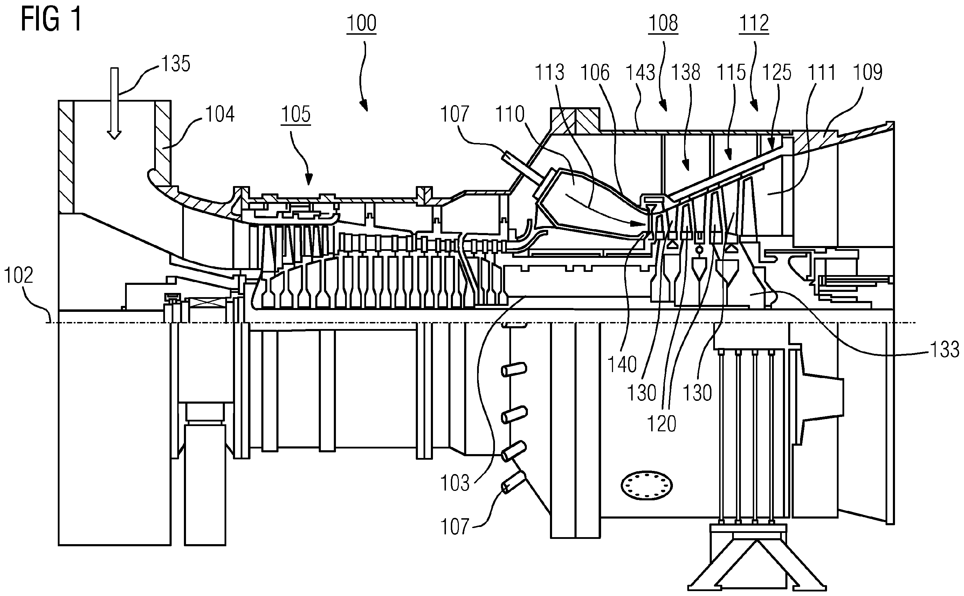

Die Figur 1 zeigt beispielhaft eine Gasturbine 100 in einem Längsteilschnitt.

Die Gasturbine 100 weist im Inneren einen um eine Rotationsachse 102 drehgelagerten Rotor 103 mit einer Welle 101 auf, der auch als Turbinenläufer bezeichnet wird.

Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.

Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium, Scandium (Sc) und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1.

Auf der MCrAlX kann noch eine Wärmedämmschicht vorhanden sein, und besteht beispielsweise aus ZrO2, Y2O3-ZrO2, d.h. sie ist nicht, teilweise oder vollständig stabilisiert durch Yttriumoxid und/oder Kalziumoxid und/oder Magnesiumoxid.

Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

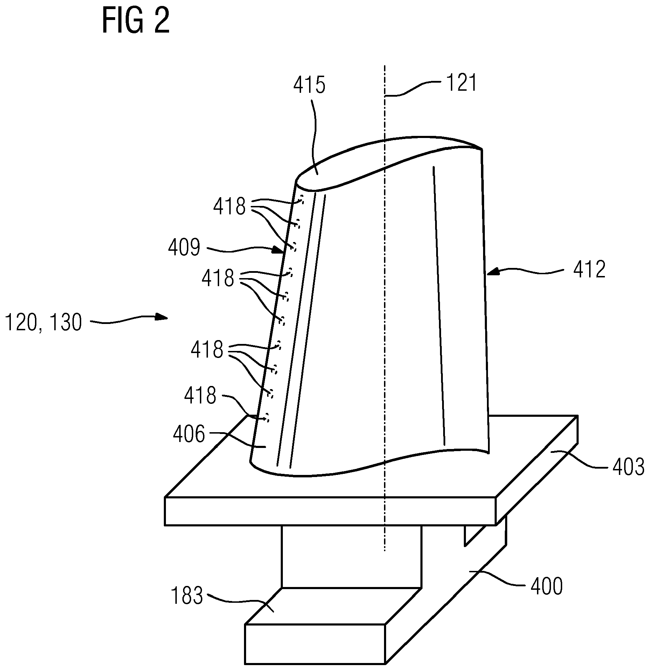

Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt) .

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abström- oder Abrisskante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Krissalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristal¬linen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichtemachen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).

Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8A1-0,6Y-0,7Si oder Co-28Ni-24Cr-10Al-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11Al-0,4Y-2Re oder Ni-25Co-17Cr-10Al-0,4Y-1,5Re.

Auf der MCrAlX kann noch eine Wärmedämmschicht vorhanden sein, die vorzugsweise die äußerste Schicht ist, und besteht beispielsweise aus ZrO2, Y2O3-ZrO2, d.h. sie ist nicht, teilweise oder vollständig stabilisiert durch Yttrium¬oxid und/oder Kalziumoxid und/oder Magnesiumoxid.
Die Wärmedämmschicht bedeckt die gesamte MCrAlX-Schicht.

Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plas¬maspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie wenigstens teilweise hohl und weist ggf. noch Filmkühllöcher 418 (gestrichelt angedeu¬tet) auf.

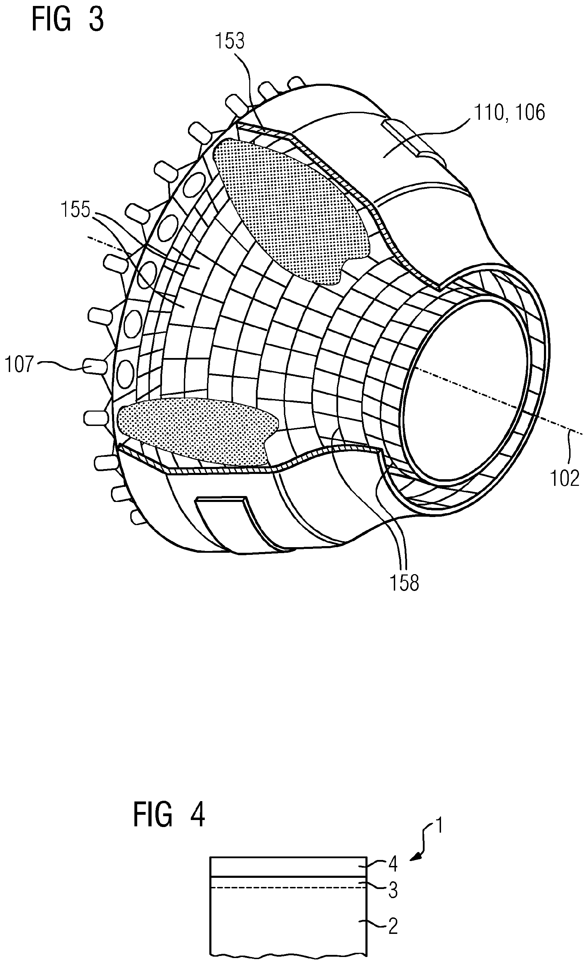

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000 C bis 1600 C ausgelegt. Um auch bei diesen, für die Materialien ungünstigen Betriebs¬parametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschild¬element 155 aus einer Legierung ist arbeits-mediumsseitig mit einer besonders hit¬zebeständigen Schutz-schicht (MCrAlX-Schicht und/oder keramische Beschichtung) ausgestattet oder ist aus hochtem¬peraturbeständigem Material (massive keramische Steine) gefertigt.

Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1.

Auf der MCrAlX kann noch eine beispielsweise keramische Wärmedämmschicht vorhanden sein und besteht beispielsweise aus ZrO2, Y2O3-ZrO2, d.h. sie ist nicht, teilweise oder vollständig stabilisiert durch Yttriumoxid und/oder Kalziumoxid und/oder Magnesiumoxid.

Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plas¬maspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in dem Hitzeschildelement 155 repariert. Danach erfolgt eine Wiederbeschichtung der Hitzeschildele¬mente 155 und ein erneuter Einsatz der Hitzeschildelemente 155.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Kühllöcher (nicht dargestellt) auf.

Figur 4 zeigt eine Teilansicht eines Querschnitts durch eine erfindungsgemäße Verdichterschaufel 1. Die Verdichterschaufel 1 weist ein Schaufelsubstrat 2 auf, das aus einem kriechfesten Stahl gefertigt ist und die aerodynamische Form der Verdichterschaufel bestimmt. An der Oberfläche des Schaufelsubstrates 2 ist eine Aluminiumdiffusionsschicht 3 vorgesehen, die durch Eindiffundieren von Aluminium in das Schaufelsubstrat 2 erzeugt wurde. Die Aluminiumdiffusionsschicht 3 kann eine Dicke von ungefähr 20 Mikrometern und einen Aluminiumgehalt von etwa 0,1 Gewichtsprozent Aluminium aufweisen. Nachdem die Aluminiumdiffusionsschicht 3 erzeugt ist, wird eine Hartstoffbeschichtung 4 auf das Schaufelsubstrat aufgebracht. Dies kann beispielsweise durch eine Abscheidung aus der Gasphase, beispielsweise durch physikalische Gasphasenabscheidung, geschehen. Die Hartstoffbeschichtung 4 schützt die Verdichterschaufel 1 vor Erosion und Korrosion. Platzt ein Teil der Hartstoffbeschichtung 4 ab, reagiert das Aluminium der derart freigelegten Aluminiumdiffusionsschicht zu Aluminiumoxid, das eine Korrosion der freigelegten Stelle des Schaufelsubstrates 2 und dadurch ein durch Unterkorrosion der benachbarten Oberflächenbereiche begünstigtes weiteres Abplatzen der Hartstoffbeschichtung 4 verhindert.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

## Patentansprüche

1. Eine neue Verdichterschaufel (1) für eine Gasturbine (100) und mit einem Schaufelsubstrat (2),
das aus einer Metalllegierung besteht und
bei der die Metalllegierung ein kriechfester Stahl ist, und an einer Oberfläche des Schaufelsubstrates (2) eine Aluminiumdiffusionszone (3) durch Eindiffundieren von Aluminium in eine Oberfläche an das Schaufelsubstrat (2) aufweist,
bei der die Aluminiumdiffusionszone (3) eine Dicke von 10 bis 30 Mikrometer, vorzugsweise von 15 bis 25 Mikrometer, aufweist,
bei der die Aluminiumdiffusionszone (3) einen Aluminiumanteil von 0,05 bis 0,2 Gewichtsprozent, vorzugsweise von 0,075 bis 0,15 Gewichtsprozent, aufweist,
und einer auf dieser Oberfläche des Schaufelsubstrates (2) angeordneten Hartstoffbeschichtung (4),
bei der die Hartstoffbeschichtung (4) aus TiN, TiAlN, AlTiN, CrN als Ein- oder Mehrschichtkeramiken besteht oder TiN, TiAlN, AlTiN, CrN als Ein- oder Mehrschichtkeramiken enthält.

2. Ein Verdichter (105) für eine Gasturbine (100) und mit einer Mehrzahl von Verdichterschaufeln (1),
wobei wenigstens eine Verdichterschaufel (1) der Mehrzahl von Verdichterschaufeln (1) gemäß Anspruch 1 ausgebildet ist.

3. Der Verdichter (105) des vorhergehenden Anspruchs, bei dem die Mehrzahl von Verdichterschaufeln (1) in einer Mehrzahl von Reihen angeordnet ist, wobei jede Reihe eine Mehrzahl von quer zu einer Hauptströmungsrichtung des Verdichters (105) angeordneten Verdichterschaufeln (1) aufweist und wobei die Mehrzahl von Reihen entlang der Hauptströmungsrichtung benachbart angeordnet sind, und bei dem die Verdichterschaufeln (1) der entlang der Hauptströmungsrichtung ersten bis vierten Reihe von Verdichterschaufeln (1) gemäß einem der Ansprüche 1 bis 2 ausgebildet sind.

4. Ein Herstellungsverfahren für eine neue Verdichterschaufel (1) gemäß einem der Ansprüche 1 bis 3 und mit den Schritten:
-- Bereitstellen eines Schaufelsubstrates (2) aus einer Metalllegierung, bei der die Metalllegierung ein kriechfester Stahl ist;
-- Eindiffundieren von Aluminium in eine Oberflächenzone des Schaufelsubstrates (2),
bei der die Aluminiumdiffusionszone (3) eine Dicke von 10 bis 30 Mikrometer, vorzugsweise von 15 bis 25 Mikrometer, aufweist,
bei der die Aluminiumdiffusionszone (3) einen Aluminiumanteil von 0,05 bis 0,2 Gewichtsprozent, vorzugsweise von 0,075 bis 0,15 Gewichtsprozent, aufweist; und
-- Beschichten des Schaufelsubstrates (2) mit einer Hartstoffbeschichtung (4),
bei der die Hartstoffbeschichtung (4) aus TiN, TiAlN, AlTiN, CrN als Ein- oder Mehrschichtkeramiken besteht oder TiN, TiAlN, AlTiN, CrN als Ein- oder Mehrschichtkeramiken enthält.

5. Das Herstellungsverfahren nach Anspruch 4,
bei dem im Schritt des Beschichtens des Schaufelsubstrates (2) mit einer Hartstoffbeschichtung (4) ein Schritt des physikalischen Gasphasenabscheidens oder des thermischen Plasmaspritzens durchgeführt wird.

## Claims

1. Novel compressor blade or vane (1) for a gas turbine (100) and having a blade or vane substrate (2),
which consists of a metal alloy and
in which the metal alloy is a creep-resistant steel, and
has an aluminium diffusion zone (3) on a surface of the blade or vane substrate (2) by virtue of diffusing aluminium into a surface on the blade or vane substrate (2),
in which the aluminium diffusion zone (3) has a thickness of 10 to 30 micrometres, preferably of 15 to 25 micrometres,
in which the aluminium diffusion zone (3) has an aluminium proportion of 0.05 to 0.2% by weight, preferably of 0.075 to 0.15% by weight,
and a hard material coating (4) arranged on said surface of the blade or vane substrate (2),
in which the hard material coating (4) consists of TiN, TiAlN, AlTiN, CrN as single-layer or multi-layer ceramics or comprises TiN, TiAlN, AlTiN, CrN as single-layer or multi-layer ceramics.

2. Compressor (105) for a gas turbine (100) and having a plurality of compressor blades or vanes (1),
wherein at least one compressor blade or vane (1) of the plurality of compressor blades or vanes (1) is designed according to Claim 1.

3. Compressor (105) according to the preceding claim, in which the plurality of compressor blades or vanes (1) are arranged in a plurality of rows, wherein each row has a plurality of compressor blades or vanes (1) arranged transversely to a main direction of flow of the compressor (105), and wherein the plurality of rows are arranged adjacent along the main direction of flow, and in which the compressor blades or vanes (1) of the first to fourth row of compressor blades or vanes (1) along the main direction of flow are designed according to either of Claims 1 and 2.

4. Method for producing a novel compressor blade or vane (1) according to one of Claims 1 to 3 and comprising the following steps:
-- providing a blade or vane substrate (2) consisting of a metal alloy, in which the metal alloy is a creep-resistant steel;
-- diffusing aluminium into a surface zone of the blade or vane substrate (2),
in which the aluminium diffusion zone (3) has a thickness of 10 to 30 micrometres, preferably of 15 to 25 micrometres,
in which the aluminium diffusion zone (3) has an aluminium proportion of 0.05 to 0.2% by weight, preferably of 0.075 to 0.15% by weight; and
-- coating the blade or vane substrate (2) with a hard material coating (4),
in which the hard material coating (4) consists of TiN, TiAlN, AlTiN, CrN as single-layer or multi-layer ceramics or comprises TiN, TiAlN, AlTiN, CrN as single-layer or multi-layer ceramics.

5. Production method according to Claim 4,
in which, in the step involving the coating of the blade or vane substrate (2) with a hard material coating (4), a step of physical vapour deposition or of thermal plasma spraying is carried out.

## Revendications

1. Nouvelle aube (1) de compresseur d'une turbine (100) à gaz et comprenant un substrat (2) d'aube,
qui est en un alliage métallique et
dans laquelle l'alliage métallique est un acier résistant au fluage et a, sur une surface du substrat (2) de l'aube, une zone (3) de diffusion d'aluminium obtenue par incorporation par diffusion d'aluminium dans une surface du substrat (2) de l'aube,
dans laquelle la zone (3) de diffusion d'aluminium a une épaisseur de 10 à 30 microns, de préférence de 15 à 25 microns,
dans laquelle la zone (3) de diffusion d'aluminium a une proportion d'aluminium de 0,05 à 0,2 pour cent en poids, de préférence de 0,075 à 0,15 pour cent en poids,
et un revêtement (4) en matériau dur disposé sur la surface du substrat (2) de l'aube,
dans laquelle le revêtement (4) en matériau dur est en TiN, TiAlN, AlTiN, CrN sous la forme d'une céramique à une couche ou à plusieurs couches ou contient du TiN, TiAlN, AlTiN, CrN sous la forme d'une céramique à une couche ou à plusieurs couches.

2. Compresseur (105) d'une turbine (100) à gaz et ayant une pluralité d'aubes (1) de compresseur,
dans lequel au moins une aube (1) du compresseur de la pluralité d'aubes (1) du compresseur est constituée suivant la revendication 1.

3. Le compresseur (105) de la revendication précédente, dans lequel la pluralité d'aubes (1) du compresseur est disposée suivant une pluralité de rangées, chaque rangée ayant une pluralité d'aubes (1) de compresseur disposées transversalement à une direction d'écoulement principale du compresseur (105) et la pluralité de rangées étant disposée en étant voisines suivant la direction d'écoulement principal, et dans lequel les aubes (1) du compresseur des première à quatrième rangées suivant la direction d'écoulement principale des aubes (1) du compresseur sont constituées suivant l'une des revendications 1 à 2.

4. Procédé de fabrication d'une nouvelle aube (1) de compresseur suivant l'une des revendications 1 à 3 et comprenant les stades :
-- on se procure un substrat (2) d'aube en un alliage métallique, l'alliage métallique étant un acier résistant au fluage ;
-- on incorpore par diffusion de l'aluminium dans une zone de surface du substrat (2) d'aube,
dans lequel la zone (3) de diffusion d'aluminium a une épaisseur de 10 à 30 microns, de préférence de 15 à 25 microns,
dans lequel la zone (3) de diffusion d'aluminium a une proportion d'aluminium de 0,5 à 0,2 pour cent en poids, de préférence de 0,075 à 0,15 pour cent en poids ; et
-- on revêt le substrat (2) de l'aube d'un revêtement (4) en un matériau dur,
dans lequel le revêtement (4) en matériau dur est en TiN, TiAlN, AlTiN, CrN sous la forme d'une céramique à une couche ou à plusieurs couches ou contient du TiN, TiAlN, AlTiN, CrN sous la forme d'une céramique à une couche ou à plusieurs couches.

5. Procédé de fabrication suivant la revendication 4,
dans lequel, dans le stade du revêtement du substrat (2) d'aube du revêtement (4) de substance dur, on effectue un stade de dépôt physique en phase gazeuse ou de pulvérisations thermiques au plasma.
